Europäisches Patentamt

European Patent Office

Office européen des brevets

(19)

Veröffentlichungsnummer: **0 300 564**

**A2**

## (12) EUROPÄISCHE PATENTANMELDUNG

(21) Anmeldenummer: 88201509.2

(22) Anmeldetag: 14.07.88

(51) Int. Cl.⁴: **G01N 24/08**

(30) Priorität: 22.07.87 DE 3724157

(43) Veröffentlichungstag der Anmeldung:
25.01.89 Patentblatt 89/04

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**

(84) **DE**

(71) Anmelder: **N.V. Philips' Gloeilampenfabrieken**
**Groenewoudseweg 1**
**NL-5621 BA Eindhoven(NL)**

(84) **FR GB NL**

(72) Erfinder: **McKinnon, Graeme Colin, Dr.**
**Höschgasse 62**
**CH-8008 Zürich(CH)**
Erfinder: **Bösiger, Peter, Dr.**
**Rebbergstrasse 73**
**CH-5400 Ennetbaden(CH)**

(74) Vertreter: **Hartmann, Heinrich, Dipl.-Ing. et al**
**Philips Patentverwaltung GmbH**
**Wendenstrasse 35 Postfach 10 51 49**
**D-2000 Hamburg 1(DE)**

(54) Kernspinuntersuchungsverfahren.

(57) Die Erfindung betrifft ein Verfahren zur Erzeugung eines selektiven 180°-Hochfrequenzimpulses mit zwei selektiven 90°-Hochfrequenzimpulsen. In der Mitte zwischen zwei Hochfrequenzimpulsen wird ein nicht selektiver 180°-Hochfrequenzimpuls erzeugt, der bewirkt, daß die angeregte Kernmagnetisierung unabhängig von der Homogenität des stationären Feldes der Kernspinuntersuchungsanordnung ist.

Fig.3

## Kernspinuntersuchungsverfahren

Die Erfindung betrifft ein Kernspinuntersuchungsverfahren, bei dem zur Erzeugung eines selektiven 180°-Hochfrequenzimpulses in Anwesenheit eines magnetischen Gradientenfeldes zwei 90°-Hochfrequenzimpulse erzeugt werden.

Ein solches Kernspinuntersuchungsverfahren ist aus der EP-OS 143 602 bekannt. Das bekannte Verfahren bezieht sich auf eine Spin-Echo-Sequenz, bei der nach einem 90°-Hochfrequenzimpuls in kurzem zeitlichen Abstand voneinander zwei 90°-Hochfrequenzimpulse in Anwesenheit eines magnetischen Gradientenfeldes erzeugt werden, die zusammen wie ein 180°-Hochfrequenzimpuls wirken sollen.

Unter einem selektiven Hochfrequenzimpuls wird hierbei und im folgenden ein Hochfrequenzimpuls verstanden, der die Kernmagnetisierung nur in einem Teil des Raumes beeinflußt, in dem das homogene stationäre Magnetfeld, das bei Kernspinuntersuchungen stets erforderlich ist, und das Feld der die Hochfrequenzimpulse erzeugenden Hochfrequenzspule wirksam sind. Unter einem 90°- bzw. einem 180°-Hochfrequenzimpuls wird dabei ein Hochfrequenzimpuls verstanden, der die Kernmagnetisierung oder Vektorkomponenten davon um 90° bzw. um 180° kippt.

Die Erzeugung von zwei dicht aufeinanderfolgenden selektiven 90°-Hochfrequenzimpulsen anstelle eines einzigen selektiven 180°-Hochfrequenzimpulses hat verschiedene Vorteile. Zum einen halbiert sich das dafür erforderliche Leistungs-Bandbreiteprodukt und zum anderen läßt sich der zeitliche Verlauf eines selektiven 90°-Hochfrequenz impulses wesentlich einfacher bestimmen als der zeitliche Verlauf eines selektiven 180°-Hochfrequenzimpulses. Für kleine Flipwinkel (das ist der Winkel, um den die Kernmagnetisierung aus der Richtung des homogenen stationären Magnetfeldes gekippt wird) gilt nämlich eine praktisch lineare Beziehung zwischen dem Spektrum des Hochfrequenzimpulses und dem Profil der Schicht, die durch diesen Hochfrequenzimpuls angeregt werden soll. Der zeitliche Verlauf eines Hochfrequenzimpulses kann also durch eine einfache Fourier-Transformation des zu dem Schichtprofil proportionalen Impulsspektrums erhalten werden. Dies gilt allerdings nur bis zu Flipwinkeln von etwa 90°. Bei Flipwinkeln von 180° versagt diese Methode, und es ist eine exakte Lösung der Blochgleichungen erforderlich. Dabei können sich technisch nur mit großem Aufwand zu erzeugende zeitliche Verläufe des Hochfrequenzimpulses ergeben.

Gleichwohl hat auch das bekannte Verfahren noch einen Nachteil, weil die Größe der Kernmagnetisierung in dem selektiv angeregten Bereich auch von der Homogenität des stationären Magnetfeldes bestimmt wird. Dies kann insbesondere bei Inversion Recovery-Sequenzen von Nachteil sein, bei denen zuerst ein selektiver 180°-Hochfrequenzimpuls erzeugt wird.

Aufgabe der vorliegenden Erfindung ist es, ein Verfahren der eingangs genannten Art so auszugestalten, das Inhomogenitäten des stationären Magnetfeldes praktisch keine Auswirkungen auf die Kernmagnetisierung in dem angeregten Bereich haben.

Diese Aufgabe wird erfindungsgemäß dadurch gelöst, daß in der Mitte zwischen den beiden selektiven 90°-Hochfrequenzimpulsen ein nicht selektiver 180°-Hochfrequenzimpuls erzeugt wird.

Die Erfindung basiert auf folgender Überlegung:
Wenn lediglich zwei selektive 90°-Hochfrequenzimpulse erzeugt werden - ohne einen 180°-Hochfrequenzimpuls dazwischen - , dann wird die durch den ersten Hochfrequenzimpuls selektiv angeregte Kernmagnetisierung unter dem Einfluß der Inhomogenität des stationären Magnetfeldes ortsabhängig dephasieren, wobei das Ausmaß der Dephasierung von der Inhomogenität des stationären Magnetfeldes sowie von dem zeitlichen Abstand der beiden 90°-Hochfrequenzimpulse voneinander abhängt. Dies führt dazu, daß beim Auftreten des zweiten selektiven 90°-Hochfrequenzimpulses nicht die gesamte Kernmagnetisierung aus ihrer zur Richtung des stationären Magnetfeldes senkrechten Richtung gekippt werden kann, sondern nur ein Teil, während der restliche Teil in der zur Richtung des stationären Magnetfeldes senkrechten Ebene verbleibt und noch weiter dephasiert oder gar wieder zurückgekippt wird.-Dadurch, daß in der Mitte zwischen den beiden selektiven 90°-Hochfrequenzimpulsen ein nicht selektiver 180°-Hochfrequenzimpuls erzeugt wird, wird nun erreicht, daß gerade in dem Augenblick, in dem der zweite Hochfrequenzimpuls auftritt, die Kernmagnetisierung in dem angeregten Bereich vollständig rephasiert ist. Durch den zweiten selektiven 90°-Hochfrequenzimpuls kann daher erreicht werden, daß die durch den ersten 90°-Hochfrequenzimpuls in eine zur Richtung des stationären Magnetfeldes senkrechte Ebene gekippte Kernmagnetisierung vollständig in die Richtung des stationären Magnetfeldes bzw. antiparallel dazu gekippt wird.

Durch den 180°-Impuls wird innerhalb und außerhalb des selektiv anzuregenden Bereiches die Kernmagnetisierung um jeweils 180° gekippt. Durch die beiden selektiven 90°-Hochfrequenzimpulse hingegen wird die Kernmagnetisierung nur innerhalb eines schichtförmigen Bereiches beeinflußt, dessen Dicke durch die Bandbreite der Hochfrequenzimpulse und die Größe des während dieser Hochfrequenzimpulse eingeschalteten magnetischen Gradientenfeldes bestimmt wird. Dies bedeutet, daß nach den erwähnten drei Hochfrequenzimpulsen die Kernmagnetisierung innerhalb der erwähnten Schicht in Richtung des stationären Magnetfeldes verläuft, und außerhalb der Schicht antiparallel dazu verläuft. Im allgemeinen ist jedoch ein umgekehrter Verlauf (innerhalb der Schicht antiparallel, außerhalb parallel) erwünscht. Dies wird nach einer Weiterbildung der Erfindung dadurch erreicht, daß vor dem ersten 90°-Hochfrequenzimpuls oder nach dem zweiten Hochfrequenzimpuls ein nicht selektiver 180°-Hochfrequenzimpuls erzeugt wird.

Eine Anordnung zur Durchführung des Verfahrens, die versehen ist mit Mitteln zur Erzeugung eines homogenen stationären Magnetfeldes, Mitteln zur Erzeugung eines dazu senkrechten hochfrequenten Magnetfeldes und Mitteln zur Erzeugung von magnetischen Gradientenfeldern, sowie mit einer Steuereinheit zur Steuerung der hochfrequenten Magnetfelder und der Gradientenfelder, ist dadurch gekennzeichnet, daß die Steuermittel so ausgelegt sind, daß gleichzeitig mit einem magnetischen Gradientenfeld ein erster 90°-Hochfrequenzimpuls erzeugt wird, daß anschließend - bei Abwesenheit von magnetischen Gradientenfeldern - ein 180°-Hochfrequenzimpuls erzeugt wird und daß nach Einschaltung des magnetischen Gradientenfeldes ein zweiter 90°-Hochfrequenzimpuls erzeugt wird, dessen zeitlicher Abstand vom 180°-Hochfrequenzimpuls halb so groß ist wie sein zeitlicher Abstand vom ersten 90°-Hochfrequenzimpuls.

Die Erfindung wird nachstehend anhand der Zeichnung näher erläutert. Es zeigen:

Fig. 1 ein Kernspinuntersuchungsgerät, bei dem die Erfindung anwendbar ist,

Fig. 2 ein Blockschaltbild eines solchen Gerätes, und

Fig. 3 die zeitliche Lage der Hochfrequenzimpulse und des magnetischen Gradientenfeldes bei dem erfindungsgemäßen Verfahren.

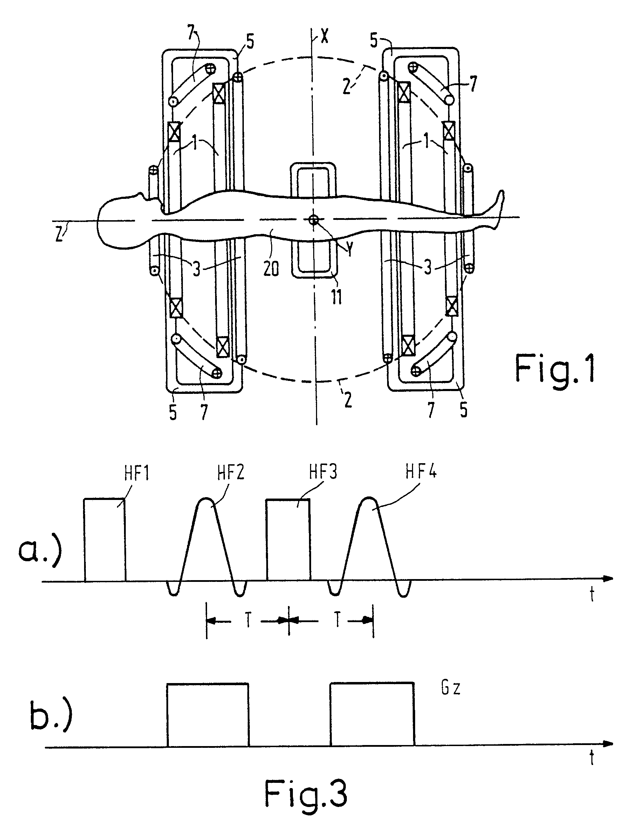

Das in Fig. 1 schematisch dargestellte Kernspintomographiegerät enthält eine aus vier Spulen 1 bestehende Anordnung zur Erzeugung eines homogenen stationären Magnetfeldes, das in der Größenordnung von einigen Zehntel T bis einigen T liegen kann. Dieses Feld verläuft in z-Richtung eines kartesischen Koordinatensystems. Die zur z-Achse konzentrisch angeordneten Spulen 1 können auf einer Kugeloberfläche 2 angeordnet sein. Im Innern dieser Spulen befindet sich der zu untersuchende Patient 20.

Zur Erzeugung eines in z-Richtung verlaufenden und sich in dieser Richtung linear ändernden Magnetfeldes Gz sind vier Spulen 3 vorzugsweise auf der gleichen Kugeloberfläche angeordnet. Weiterhin sind vier Spulen 7 vorgesehen, die ein ebenfalls in z-Richtung verlaufendes magnetisches Gradientenfeld ( d.h. ein Magnetfeld, dessen Stärke sich in einer Richtung linear ändert) Gx erzeugen, dessen Gradient jedoch in x-Richtung verläuft. Ein in z-Richtung verlaufendes magnetisches Gradientenfeld Gy mit einem Gradienten in y-Richtung wird von vier Spulen 5 erzeugt, die die gleiche Form haben können wie die Spulen 7, die jedoch diesen gegenüber um 90° versetzt angeordnet sind. Von diesen vier Spulen sind in Fig. 1 nur zwei dargestellt.

Da jede der drei Spulenanordnungen 3, 5 und 7 zur Erzeugung der magnetischen Gradientenfelder Gz, Gy und Gx symmetrisch zur Kugeloberfläche 2 angeordnet ist, ist die Feldstärke im Kugelzentrum, das gleichzeitig den Koordinatenursprung des erwähnten kartesischen xyz-Koordinatensystems bildet, nur durch das stationäre homogene Magnetfeld der Spulenanordnung bestimmt.

Weiterhin ist eine Hochfrequenzspule 11 symmetrisch zur Ebene z = 0 des Koordinatensystems angeordnet, die so ausgebildet ist, daß damit ein im wesentlichen homogenes und in x-Richtung, d.h. senkrecht zur Richtung des stationären homogenen Magnetfeldes, verlaufendes hochfrequentes Magnetfeld erzeugt wird. Der Hochfrequenzspule wird während jedes Hochfrequenzimpulses ein hochfrequenter Strom von einem Hochfrequenzgenerator 4 zugeführt. - Im Anschluß an einen oder mehrere Hochfrequenzimpulse kann die Hochfrequenzspule 11 zum Empfangen von im Untersuchungsbereich erzeugten Kernspin-Resonanzsignalen dienen. Stattdessen kann für diese Zwecke aber auch eine gesonderte Hochfrequenz-Empfangsspule verwendet werden.

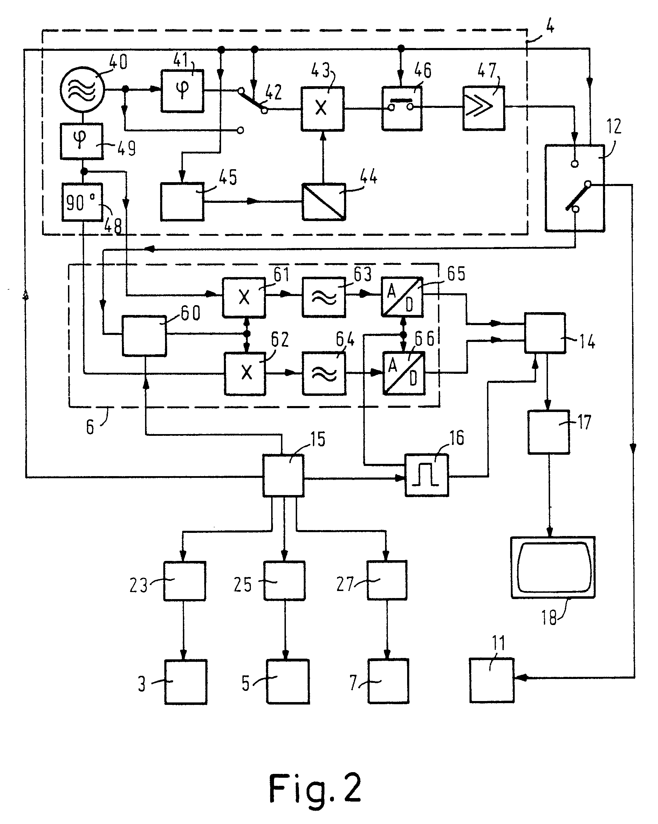

Fig. 2 zeigt ein vereinfachtes Blockschaltbild eines solchen Kernspinuntersuchungsgerätes. Die Hochfrequenzspule 11 ist über eine Umschalteinrichtung 12 einerseits an einen Hochfrequenzgenerator 4 und andererseits an einen Hochfrequenzempfänger 6 angeschlossen.

Der Hochfrequenzgenerator 4 enthält einen in seiner Frequenz digital steuerbaren Hochfrequenzoszillator 40, der Schwingungen mit einer Frequenz gleich der Larmor-frequenz der anzuregenden Atomkerne bei der von den Spulen 1 erzeugten Feldstärke liefert. Die Larmorfrequenz f berechnet sich bekanntlich nach der Beziehung $f = cB$, wobei B die magnetische Induktion in dem stationären homogenen Magnetfeld darstellt und c das gyromagnetische Verhältnis, das beispielsweise für Protonen 42,56 MHz/T beträgt. Der Ausgang des Oszillators 40 ist mit einem Eingang einer Mischstufe 43 verbunden. Der Mischstufe 43 wird ein zweites Eingangssignal von einem Digital-Analog-Wandler 44 zugeführt, dessen Ausgang mit einem digitalen Speicher 45 verbunden ist. Aus dem Speicher wird - gesteuert durch eine Steuereinrichtung 15 - eine Folge von ein Hüllkurvensignal darstellenden digitalen Datenworten ausgelesen.

Die Mischstufe 43 verarbeitet die ihr zugeführten Eingangssignale so, daß an ihrem Ausgang die mit dem Hüllkurvensignal modulierte Trägerschwingung erscheint. Das Ausgangssignal der Mischstufe 43 wird über einen von der Steuereinrichtung 15 gesteuerten Schalter 46 einem Hochfrequenz-Leistungsverstärker 47 zugeführt, dessen Ausgang mit der Umschalteinrichtung 12 verbunden ist. Diese wird ebenfalls durch die Steuereinrichtung 15 gesteuert.

Der Empfänger 6 enthält einen Hochfrequenzverstärker 60, der mit der Umschalteinrichtung verbunden ist und dem das in der Hochfrequenzspule 11 induzierte Echosignal zugeführt wird, wobei die Umschalteinrichtung den entsprechenden Schaltzustand haben muß. Der Verstärker 60 besitzt einen von der Steuereinrichtung 15 gesteuerten Stummschalteingang, über den er gesperrt werden kann, so daß die Verstärkung praktisch Null ist. Der Ausgang des Verstärkers ist mit den ersten Eingängen zweier multiplikativer Mischstufen 61 und 62 verbunden, die jeweils ein dem Produkt ihrer Eingangssignale entsprechendes Ausgangssignal liefern. Den zweiten Eingängen der Mischstufen 61 und 62 wird ein Signal mit der Frequenz des Oszillators 40 zugeführt, wobei zwischen den Signalen an den beiden Eingängen eine Phasenverschiebung von $90°$ besteht. Diese Phasenverschiebung wird mit Hilfe eines $90°$ Phasendrehgliedes 48 erzeugt, dessen Ausgang mit dem Eingang der Mischstufe 62 und dessen Eingang mit dem Eingang der Mischstufe 61 und mit dem Ausgang des Oszillators 40 verbunden ist.

Die Ausgangssignale der Mischstufe 61 und 62 werden über Tiefpässe 63 und 64, die die vom Oszillator 40 gelieferte Frequenz sowie alle darüberliegenden Frequenzen unterdrücken und niederfrequente Anteile durchlassen, je einem Analog-Digital-Wandler 65 bzw. 66 zugeführt. Dieser setzt die analogen Signale der einen Quadratur-Demodulator bildenden Schaltung 61...64 in digitale Datenworte um, die einem Speicher 14 zugeführt werden. Die Analog-Digital-Wandler 65 und 66 sowie der Speicher 14 erhalten ihre Taktimpulse von einem Taktimpulsgenerator 16, der über eine Steuerleitung von der Steuereinrichtung 15 blockiert bzw. freigegeben werden kann, so daß nur in einem durch die Steuereinrichtung 15 definierten Meßintervall die von der Hochfrequenzspule 11 gelieferten, in den Niederfrequenzbereich transponierten Signale in eine Folge digitaler Datenworte umgesetzt und in dem Speicher 14 gespeichert werden können.

Die drei Spulenanordnungen 3, 5 und 7 werden von Stromgeneratoren 23, 25 und 27 jeweils mit einem Strom versorgt, dessen zeitlicher Verlauf durch die Steuereinheit 15 steuerbar ist. Die im Speicher 14 gespeicherten Datenworte bzw. Abtastwerte werden einem Rechner zugeführt, der daraus durch eine diskrete Fourier-Transformation die spektrale Verteilung der Kernmagnetisierung ermittelt und an einer geeigneten Wiedergabeeinheit, z.B. einem Monitor 18, ausgibt.

Fig. 3 zeigt die zeitliche Lage der Hochfrequenzimpulse relativ zueinander und in bezug auf das zur Schichtselektion dienende magnetische Gradientenfeld, wobei in Fig. 3a die Hochfrequenzimpulse und in Fig. 3b das magnetische Gradientenfeld dargestellt sind. Gemäß Fig. 3a wird zunächst ein erster nicht selektiver $180°$-Hochfrequenzimpuls HF1 erzeugt. Dieser Hochfrequenzimpuls kann relativ schmalbandig sein und eine relativ geringe Leistung aufweisen. Da während dieses Hochfrequenzimpulses kein magnetisches Gradientenfeld eingeschaltet ist, wird die Kernmagnetisierung in dem gesamten, von der Spule 11 erfaßten Bereich um $180°$ d.h. in die zum stationären Feld antiparallele (-z) Richtung gekippt.

Nach dem ersten nicht selektiven $180°$-Hochfrequenzimpuls HF1 folgt ein erster selektiver $90°$-Hochfrequenzimpuls HF2. Die Steuereinheit 15 steuert den Stromgenerator 23 für die Gradientenspulen 3 so, daß während des Hochfrequenzimpulses HF2 ein magnetisches Gradientenfeld Gz mit in z-Richtung verlaufendem Gradienten wirksam ist. Der Hochfrequenzimpuls HF2 beeinflußt daher die Kernmagnetisierung lediglich in einer zur z-Achse senkrechten Schicht, deren Dicke durch die Bandbreite des Hochfrequenzimpulses HF2 und durch den Gradienten des magnetischen Gradientenfeldes bestimmt ist. Der Hochfrequenzimpuls bewirkt, daß in der erwähnten Schicht die Kernmagnetisierung um $90°$ aus der -z-Richtung in die x-y-Ebene gekippt wird.

Nach einer Zeit T nach dem ersten selektiven $90°$-Hochfrequenzimpuls HF2 folgt ein zweiter nicht selektiver $180°$-Hochfrequenzimpuls HF3, der den gleichen zeitlichen Verlauf haben kann wie der Hochfrequenzimpuls HF1. Da während dieses Hochfrequenzimpulses kein magnetisches Gradientenfeld eingeschaltet ist, beeinflußt er die Kernmagnetisierung sowohl innerhalb als auch außerhalb der Schicht. Außerhalb der Schicht wird durch den Hochfrequenzimpuls HF3 die Kernmagnetisierung wieder in die +z-Richtung zurückgekippt, in der sie sich vor dem ersten Hochfrequenzimpuls HF1 befand. Die Kernmagnetisierung in der durch den Hochfrequenzimpuls HF2 angeregten Schicht bleibt auch nach der Anregung in der x-y-Ebene. Jedoch bewirkt der Hochfrequenzimpuls HF3, daß innerhalb der Schicht die Kernmagnetisierung, die nach dem selektiven Hochfrequenzimpuls HF2 zunächst durch die Inhomogenitäten des stationären Magnetfeldes dephasiert, wieder rephasiert, so daß zur Zeit T nach dem zweiten 180°-Hochfrequenzimpuls HF3 die Kernmagnetisierung überall in der angeregten Schicht die gleiche Phase hat.

Aus diesem Grund wird zur Zeit T nach dem zweiten 180°-Hochfrequenzimpuls HF3 ein zweiter selektiver 90°-Hochfrequenzimpuls HF4 eingeschaltet. Dieser Hochfrequenzimpuls kann den gleichen zeitlichen Verlauf haben wie der Hochfrequenzimpuls HF2, und während dieses Hochfrequenzimpulses ist wiederum das magnetische Gradientenfeld Gz mit der gleichen Größe des Gradienten wirksam. Dadurch wird die Kernmagnetisierung in der angeregten Schicht um die gleiche zur z-Achse senkrechte Achse gekippt wie beim ersten Hochfrequenzimpuls und mit dem gleichen Drehsinn, so daß die Kernmagnetisierung innerhalb der Schicht in -z-Richtung verläuft, während sie außerhalb der Schicht in +z-Richtung verbleibt.

Die vier Hochfrequenzimpulse HF1...HF4 haben also die Wirkung eines selektiven 180°-Hochfrequenzimpulses. Ein solcher Hochfrequenzimpuls kann Teil einer Sequenz sein, die in Fig. 3 nicht näher dargestellt ist. Eine solche Sequenz kann im Anschluß an die vier Hochfrequenzimpulse HF1...HF4 weitere Hochfrequenzimpulse enthalten, z.B. einen 90°-Hochfrequenzimpuls, wie bei einer Inversion Recovery-Sequenz. Zur Erzeugung eines Kernspintomogramms können dabei weitere gleichartige Sequenzen erzeugt werden, wobei lediglich von Sequenz zu Sequenz Amplitude und Dauer eines der Gradientenfelder Gx, Gy variiert wird.

Im allgemeinen wird die Polarität des mit einem selektiven Hochfrequenzimpuls verknüpften magnetischen Gradientenfeldes nach dem Hochfrequenzimpuls umgekehrt und danach abgeschaltet, derart, daß das zeitliche Integral über das magnetische Gradientenfeld von der Mitte des Hochfrequenzimpulses bis zum Abschalten gerade den Wert Null hat. Dadurch soll erreicht werden, daß die Phasenlage der Kernmagnetisierung in Richtung senkrecht zur angeregten Schicht unabhängig vom Ort ist. Eine solche Ausgestaltung des zeitlichen Verlaufs des magnetischen Gradientenfeldes kann zwar auch bei den Hochfrequenzimpulsen HF2 und HF4 angewandt werden, doch ist dies nicht erforderlich. Wenn nämlich nach dem ersten 90°-Hochfrequenzimpuls die Phase der Kernmagnetisierung ortsabhängig wäre, würde durch den zweiten 180°-Hochfrequenzimpuls HF3 bewirkt, daß beim Auftreten des 90°-Hochfrequenzimpulses HF4 die Phasenlage der Kernmagnetisierung innerhalb der Schicht überall gleich ist. - Nach dem zweiten selektiven 90°-Hochfrequenzimpuls HF4 verläuft die Kernmagnetisierung innerhalb der Schicht antiparallel zur Richtung des stationären Magnetfeldes. Da es hierbei - anders als wenn die Kernmagnetisierung sich in der xy-Ebene befindet - weder zu einer Dephasierung noch zu einer Rephasierung kommen kann, ist es unbeachtlich, daß das mit dem zweiten 90°-Hochfrequenzimpuls HF4 verknüpfte magnetische Gradientenfeld im Anschluß an diesen Impuls seine Polarität nicht ändert.

Bei dem beschriebenen Beispiel verläuft der Gradient des magnetischen Gradientenfeldes beim ersten und beim zweiten 90°-Hochfrequenzimpuls HF2 bzw. HF4 in derselben Richtung. Es ist jedoch auch möglich, daß der Gradient beim zweiten Hochfrequenzimpuls in der entgegengesetzten Richtung verläuft wie beim ersten Hochfrequenzimpuls. Dies läßt sich dadurch erreichen, daß die Polarität des vom Stromgenerator 23 erzeugten, die Gradientenspule 3 durchfließenden Stromes beim zweiten 90°-Hochfrequenzimpuls HF4 invertiert wird.

Anstelle einer zur z-Achse senkrechten Schicht kann auch eine anders orientierte Schicht angeregt werden, beispielsweise eine zur x- bzw. y-Achse senkrechte Schicht. In diesem Fall muß der Stromgenerator 25 bzw. 27 zur Speisung der Gradientenspulen 5 bzw. 7 einen entsprechenden Strom liefern. Wesentlich ist auch hier, daß das magnetische Gradientenfeld beim zweiten Hochfrequenzimpuls in der gleichen oder in der entgegengesetzten Richtung verläuft wie beim ersten Hochfrequenzimpuls.

## Ansprüche

1. Kernspinuntersuchungsverfahren, bei dem zur Erzeugung eines selektiven 180°-Hochfrequenzimpulses in Anwesenheit eines magnetischen Gradientenfeldes zwei 90°-Hochfrequenzimpulse erzeugt werden,
dadurch gekennzeichnet, daß in der Mitte zwischen den beiden selektiven 90°-Hochfrequenzimpulsen (HF2, HF4) ein nicht selektiver 180°-Hochfrequenzimpuls (HF3) erzeugt wird.

2. Kernspinuntersuchungsverfahren nach Anspruch 1,
dadurch gekennzeichnet, daß vor dem ersten 90°-Hochfrequenzimpuls (HF2) oder nach dem zweiten 90°-Hochfrequenzimpuls ein nicht selektiver 180°-Hochfrequenzimpuls (HF1) erzeugt wird.

3. Anordnung zur Durchführung des Verfahrens nach Anspruch 1 mit Mitteln zur Erzeugung eines homogenen stationären Magnetfeldes, Mitteln zur Erzeugung eines dazu senkrechten hochfrequenten Magnetfeldes und Mitteln zur Erzeugung von magnetischen Gradientenfeldern, sowie mit einer Steuereinheit zur Steuerung der hochfrequenten Magnetfelder und der Gradientenfelder,
dadurch gekennzeichnet, daß die Steuermittel 15 so ausgelegt sind, daß gleichzeitig mit einem magnetischen Gradientenfeld (Gz) ein erster 90°-Hochfrequenzimpuls (HF2) erzeugt wird, daß anschließend - bei Abwesenheit von magnetischen Gradientenfeldern - ein 180°-Hochfrequenzimpuls (HF3) erzeugt wird und daß nach Einschaltung des magnetischen Gradientenfeldes ein zweiter 90°-Hochfrequenzimpuls (HF4) erzeugt wird, dessen zeitlicher Abstand (T) vom 180°-Hochfrequenzimpuls halb so groß ist wie sein zeitlicher Abstand (2T) vom ersten 90°-Hochfrequenzimpuls.

Fig.1

a.)

b.)

Fig.3

Fig. 2